# EUROPEAN PATENT APPLICATION

(11) **EP 2 784 487 A1**
(43) Date of publication of application: **01.10.2014**
(21) Application number: 14161618.5
(22) Date of filing: 25.03.2014
(51) Int. Cl.: G01N 21/51

(54) **Apparatus and method for measuring turbidity**

(30) Priority: 25.03.2013 KR 20130031505
(71) Applicant: Samsung SDI Co., Ltd., Yongin-si, Gyeonggi-do (KR)
(72) Inventor: Kang, Suk-Jun, Gyeonggi-do (KR); Song, Young-Wook, Gyeonggi-do (KR); Jang, Yeon-Ik, Gyeonggi-do (KR)
(74) Representative: Taor, Simon Edward William

(57) **Abstract**

An apparatus for measuring turbidity includes a first storage portion configured to store a measuring fluid therein, a measuring container connected to the first storage portion through first and second pipes, and a turbidity measuring portion configured to measure turbidity of the measuring fluid in the measuring container, at least a portion of the measuring fluid being moved between the first storage portion and the measuring container through the first and second pipes.

## Description

An aspect of example embodiments relates to an apparatus and a method for measuring turbidity.

As energy demands increase, demands on solar cells for converting solar energy into electrical energy have recently been increased. The solar cells are clean energy sources which produce electricity from the sun, which is an infinite energy source. The solar cells have come into the spotlight as new growth power in the world with a remarkable industrial growth rate every year.

Among the solar cells, a CIGS solar cell is a solar cell which can be implemented with a thin film and does not use Si at all. CIGS solar cells are expected to play a great role by lowering production costs of solar cells. Further, since CIGS solar cells have excellent thermal stability, their efficiency is hardly decreased even after time elapses. Accordingly, various studies have been conducted to improve the electricity-generating ability of CIGS solar cells.

Embodiments provide an apparatus and a method for measuring turbidity, which can detect, in real time, a degree of homogeneity of a chemical solution for growing a specific layer in a solar cell.

According to an aspect of example embodiments, there is provided an apparatus for measuring turbidity, including a first storage portion configured to store a measuring fluid therein, a measuring container connected to the first storage portion through first and second pipes, and a turbidity measuring portion configured to measure turbidity of the measuring fluid in the measuring container, at least a portion of the measuring fluid being moved between the first storage portion and the measuring container through the first and second pipes.

The pipe may be configured to transfer the at least portion of the measuring fluid from the first storage portion into the measuring container, and the second pipe may be configured to transfer the at least portion of the measuring fluid from the measuring container into the first storage portion.

The measuring container may include a first pipe connecting portion connected to the first pipe, and a second pipe connecting portion connected to the second pipe and positioned higher than the first pipe connecting portion, the measuring fluid flowing into the measuring container through the first pipe and flowing out of the measuring container through the second pipe.

The first pipe may include a first valve configured to control the flow of the measuring fluid, and the second pipe includes a second valve configured to control the flow of the measuring fluid.

The turbidity measuring portion may include a light emitting portion configured to irradiate light onto a surface of the measuring fluid, and a light receiving portion configured to collect light irradiated from the light emitting portion and light spread from the measuring fluid.

The light emitting portion and the light receiving portion may be positioned outside the measuring fluid, the light emitting portion and the light receiving portion being adjacent to a surface of the measuring fluid in the measuring container.

The measuring container may include a third valve configured to discharge the measuring fluid from the measuring container.

At least one of the first and second pipes may include a pH measuring device configured to measure pH of the measuring fluid.

The apparatus may further include a second storage portion connected to the first pipe, the second storage being configured to store a cleansing fluid therein.

The first pipe may include a fourth valve configured to control flow of the cleansing fluid in the first pipe.
The second pipe may include a fifth valve configured to discharge the cleansing fluid from the second pipe to the outside.

The first pipe may include a pump portion configured to transfer the measuring fluid into the measuring container.

According to another aspect of example embodiments, there is provided a method for measuring turbidity, including allowing at least a portion of a measuring fluid flow from a first storage portion into a measuring container through a first pipe, measuring the turbidity of the measuring fluid in the measuring container with a turbidity measuring portion, and allowing the at least portion of the measuring fluid flow from the measuring container into the first storage portion through a second pipe.

Measuring the turbidity of the measuring fluid may include irradiating light onto a surface of the measuring fluid by a light emitting portion, and collecting light irradiated from the light emitting portion and light spread from the measuring fluid by a light receiving portion.

Allowing the at least portion of the measuring fluid flow from the first storage portion may include measuring pH of the measuring fluid using a pH measuring device connected to the first pipe.

The method may further include closing a first valve connected to the first pipe and closing a second valve connected to the second pipe, such that movement of the measuring fluid is prevented, discharging the measuring fluid from the measuring container by opening a third valve connected to the measuring container, closing the third valve connected to the measuring container, opening a fourth valve connected to the first pipe, such that a cleansing fluid flows into the measuring container from a second storage portion connected to the first pipe, and opening a fifth valve connected to the second pipe, such that the cleansing fluid is discharged from the measuring container through the second pipe.

According to a first aspect of the invention, there is provided an apparatus for measuring turbidity as set out in claim 1. Preferred features of this aspect are set out in claims 2 to 11.

According to a second aspect of the invention, there is provided a method for measuring turbidity as set out in claim 12. Preferred features of this aspect are set out in claims 13 to 15.

Features will become apparent to those of ordinary skill in the art by describing in detail exemplary embodiments with reference to the attached drawings, in which:
FIG. 1 illustrates a schematic view of an apparatus for measuring turbidity according to an embodiment.
FIG. 2 illustrates a schematic view of an apparatus for measuring turbidity according to another embodiment.
FIG. 3 illustrates a schematic view of an apparatus for measuring turbidity according to still another embodiment.
FIG. 4 illustrates a flowchart of a method for measuring turbidity according to an embodiment.
FIGS. 5 to 7 illustrate schematic views of the method shown in FIG. 4.
FIG. 8 illustrates a flowchart of a method for measuring turbidity according to another embodiment.
FIGS. 9 to 12 illustrate schematic views of the method shown in FIG. 8.

In the following detailed description, only certain exemplary embodiments have been shown and described, simply by way of illustration. As those skilled in the art would realize, the described embodiments may be modified in various different ways, all without departing from the inventive spirit or scope. Accordingly, the drawings and description are to be regarded as illustrative in nature and not restrictive. In addition, when an element is referred to as being "on" another element, it can be directly on the other element or be indirectly on the other element with one or more intervening elements interposed therebetween. Also, when an element is referred to as being "connected to" another element, it can be directly connected to the other element or be indirectly connected to the other element with one or more intervening elements interposed therebetween. Hereinafter, like reference numerals refer to like elements.

Terms or words used in this specification and claims should not be restrictively interpreted as ordinary meanings or dictionary-based meanings, but should be interpreted as meanings and concepts conforming to the scope of the example embodiments on the basis of the principle that an inventor can properly define the concept of a term to describe and explain his or her invention in the best ways.

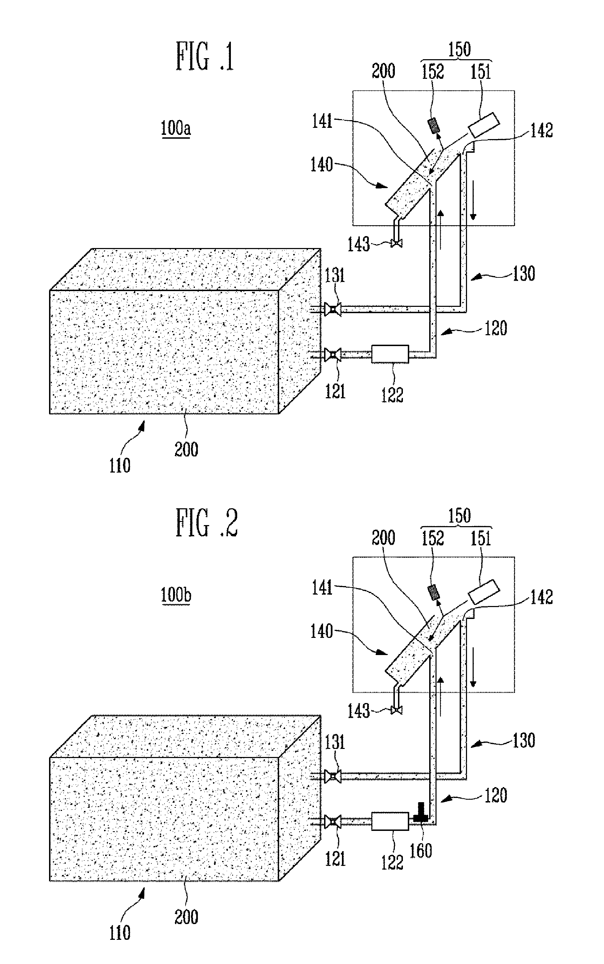

FIG. 1 illustrates a schematic view of an apparatus 100a for measuring turbidity according to an embodiment. Hereinafter, the apparatus 100a according to this embodiment will be described with reference to FIG. 1.

As shown in FIG. 1, the apparatus 100a according to this embodiment may include a first storage portion 110 (first storage unit), a first pipe 120, a second pipe 130, a measuring container 140, and a turbidity measuring portion 150 (turbidity measuring portion unit). In some embodiments, the turbidity measuring portion 150 may comprise a single turbidity measuring device or comprise a number of distributed components.

The first storage portion 110 is a member that stores a measuring fluid 200 therein. The storage portion 110 may be connected to, e.g., in fluid communication with, the first and second pipes 120 and 130.

The measuring fluid 200 may be, e.g., a chemical solution used to grow a buffer layer of a solar cell. Therefore, the measuring fluid 200 may include, e.g., CdS, ZnS or the like. The measuring fluid 200 may include particles, e.g., colloids. The first storage portion 110 may be a main bath in which the measuring fluid 200 is stored, and may be connected to the measuring container 140 through the first and second pipes 120 and 130.

The first pipe 120 may allow the measuring fluid 200 stored in the first storage portion 110 to flow from the first storage portion 110 into the measuring container 140, and the second pipe 130 may allow the measuring fluid 200 in the measuring container 140 to flow from the measuring container 140 into the first storage portion 110. That is, the measuring fluid 200 may be moved between the first storage portion 110 and the measuring container 140 through the first and second pipes 120 and 130. Therefore, the apparatus 100a according to this embodiment may be a real-time in-situ monitoring system that moves, e.g., at least a portion of, the measuring fluid 200 between the first storage portion 110 and the measuring container 140, rather than extracting, e.g., completely removing, a certain amount of sample from the first storage portion 110.

Accordingly, it is less likely that in the measurement of the turbidity, according to example embodiments, a measurement error will occur due to environmental influences. Further, the measurement of the turbidity, according to example embodiments, may be performed more than once, e.g., multiple times and/or periodically during film formation, thereby providing convenience of a process and accuracy. In this case, at least one of the first and second pipes 120 and 130 may include a pump portion 122 in order to facilitate the movement of the measuring fluid 200. In this embodiment, the measuring fluid 200 flows into the measuring container 140 through the first pipe 120, so the pump portion 122 may be mounted on the first pipe 120.

The first and second pipes 120 and 130 may respectively include first and second valves 121 and 131 so as to control the flow of fluid flowing in each pipe. However, the first and second valves 121 and 131 are not necessarily installed in the respective first and second pipes 120 and 130. For example, the first and second valves 121 and 131 may be installed at a connection portion between the first storage portion 110 and respective pipes, or between a connection portion between the measuring container 140 and respective pipes.

The first storage portion 110 may be connected to a separate film growing apparatus so as to provide the measuring fluid 200 to the film growing apparatus. Accordingly, a film growth layer can be formed by the measuring fluid 200 in the solar cell, while measuring the turbidity of the measuring fluid 200 in real time. For example, as will be apparent to a person of ordinary skill in the art from the foregoing description and from the drawings, a portion of the measuring fluid 200 may be moved from the first storage portion 110 through the first pipe 120 into the measuring container 140 for testing, while another portion of the measuring fluid 200 may be moved, e.g., simultaneously, from the first storage portion 110 to the separate film growing apparatus. Accordingly, turbidity measurement of the measuring fluid 200 may be performed simultaneously and in real time as the film formation.

The measuring container 140 may be connected to the first storage portion 110 through the first and second pipes 120 and 130 so as to provide space for measuring the turbidity of the measuring fluid 200. The measuring container 140 may be connected to the first pipe 120 through a first pipe connecting portion 141 (first pipe connecting unit), and may be connected to the second pipe 130 through a second pipe connecting portion 142 (second pipe connecting unit). In this case, the second pipe connecting portion 142 may be positioned higher than the first pipe connection portion 141. For example, as will be apparent to a person of ordinary skill in the art from the foregoing description and from the drawings, an edge of the second pipe connecting portion 142 may contact the measuring container 140 at a higher point than the first pipe connection portion 141 relative to a bottom of the measuring container 140. Accordingly, the measuring fluid 200 may flow into the measuring container 140 through the first pipe 120 and out of the measuring container 140 through the second pipe 130, while a surface of the measuring fluid 200 maintains a gradual raise in the measuring container 140, e.g., a surface level of the measuring fluid 200 in the measuring container 140 may increase only gradually. Thus, the measuring fluid 200 filling the measuring container 140 may maintain an entirely stabilized surface, e.g., a top surface of the measuring fluid 200 in the measuring container 140 may have minimized or nonexistent turbulence.

In contrast, if the first pipe connecting portion 141 were to be positioned higher than the second pipe connecting portion 142, vibration could be generated on the surface of the measuring fluid 200, e.g., by the measuring fluid 200 dropping from the first pipe connecting portion 141. Therefore, positioning of the first pipe connecting portion 141 higher than the second pipe connecting portion 142 may cause the surface of the measuring fluid 200 to become unstable, thereby requiring a separate vibration damping member or the like, which in turn, may increase costs.

Meanwhile, a third valve 143 may be connected to a lower end, e.g., bottom, of the measuring container 140, and is closed at ordinary times. In a case when the measuring fluid 200 is not required in the measuring container 140, e.g., due to completion of measurement, the third valve 143 may be opened to allow the measuring fluid 200 to flow out of the measuring container 140.

The turbidity measuring portion 150 is a member that measures the turbidity of the measuring fluid 200 filling the measuring container 140. For example, the turbidity measuring portion 150 may include a light emitting portion 151 (light emitting unit) and a light receiving portion 152 (light receiving unit). In this case, the light emitting portion 151 may directly irradiate light onto the measuring fluid 200 in the measuring container 140, and the light receiving portion 152 may directly collect light irradiated from the light emitting portion 151 and light spread from the measuring fluid 200, e.g., light reflected or refracted from particles in the measuring fluid 200.
Here, the terms "direct irradiation" and "direct collection" refer to direct irradiation onto the surface of the measuring fluid 200 and direction collection of light reflected or refracted from the surface of the measuring fluid 200 without passing through a separate pipe, etc. Since the measuring fluid 200 contains particles, e.g., colloids, irradiation or collection of light through a separate pipe, etc. may make the measurement difficult due to the growth of the particles in the pipe, etc. In order to solve such a problem, the apparatus 100a according to this embodiment can directly irradiate light onto the surface of the measuring fluid 200 and collect the light reflected or refracted from the surface of the measuring fluid 200.

The light emitting portion 151 and the light receiving portion 152 are not sunk in the measuring fluid 200 but may be positioned outside of the measuring fluid 200, while being adjacent to the surface of the measuring fluid 200. This is because it is difficult to properly collect light due to the formation of a film in the light receiving portion 152, e.g., when the light receiving portion 152 is sunk in the measuring fluid 200.

Accordingly, the turbidity of the measuring fluid 200 is measured through the turbidity measuring portion 150, so that it is possible to detect the degree of homogeneity of the measuring fluid 200 in real time.

FIG. 2 illustrates a schematic view of an apparatus 100b for measuring turbidity according to another embodiment. Hereinafter, the apparatus 100b according to this embodiment will be described with reference to FIG. 2. Here, components identical or corresponding to those of the aforementioned embodiment are designated by like reference numerals, and their detailed descriptions will be omitted to avoid redundancy.

The apparatus 100b according to this embodiment may include the first storage portion 110, the measuring container 140, the turbidity measuring portion 150, the first pipe 120 and, the second pipe 130. The first pipe 120 and/or the second pipe 130 may further include a pH measuring device 160.

For example, as illustrated in FIG. 2, the pH measuring device 160 may be included in the first pipe 120, and the pH of the measuring fluid 200 supplied into the measuring container 140 through the first pipe 120 may be measured using the pH measuring device 160. In a case where the pH of the measuring fluid 200 is measured, it is possible to detect the concentration of ammonia (NH₃) in the measuring fluid 200. Thus, the apparatus 100b according to this embodiment measures not only the turbidity of the measuring fluid 200 but also the pH of the measuring fluid 200, thereby obtaining various characteristics of the measuring fluid 200.

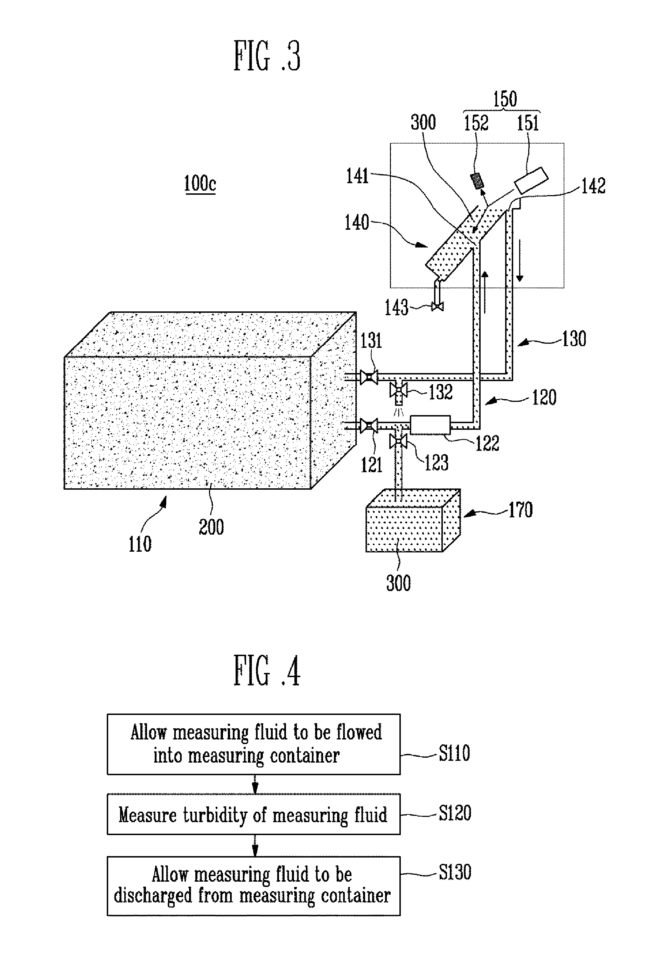

FIG. 3 illustrates a schematic view of an apparatus 100c for measuring turbidity according to still another embodiment. Hereinafter, the apparatus 100c according to this embodiment will be described with reference to FIG. 3. Here, components identical or corresponding to those of the aforementioned embodiments are designated by like reference numerals, and their detailed descriptions will be omitted to avoid redundancy.

The apparatus 100c according to this embodiment may further include a second storage portion 170 (second storage unit) storing a cleansing fluid 300, in addition to the first storage portion 110, the measuring container 140, and the turbidity measuring portion 150.

Here, the cleansing fluid 300 may be stored in the second storage portion 170, and the second storage portion 170 may be connected to the first pipe 120. In this case, the first pipe 120 may further include a fourth valve 123 for controlling the flow of the cleansing fluid 300. The fourth pipe 123 is closed while the turbidity of the measuring fluid 200 is being measured, and may be opened when a cleansing operation is performed. The second pipe 130 may further include a fifth valve 132 for discharging the cleansing fluid 300 to the outside. The fifth valve 132 is closed while the turbidity of the measuring fluid 200 is being measured, and may be opened when the cleansing operation is performed. In this case, the first and second valves 121 and 131 are open while the turbidity of the measuring fluid 200 is being measured, and are closed when the cleansing operation is performed. The third valve 143 may be opened to remove the measuring fluid 200 remaining in the measuring container 140, and may close again before the cleansing operation is performed.

Meanwhile, if the fourth valve 123 is open, the cleansing fluid 300 stored in the second storage portion 170 flows into the measuring container 140 via the first pipe 120. The cleansing fluid 300 overflowing from the measuring container 140 may be discharged to the outside through the fifth valve 132 in the second pipe 130. Thus, of a film growth layer of the measuring fluid 200 is formed in the first pipe 120, the second pipe 130, and/or the measuring container 140, such layer may be removed with the cleansing fluid 300.

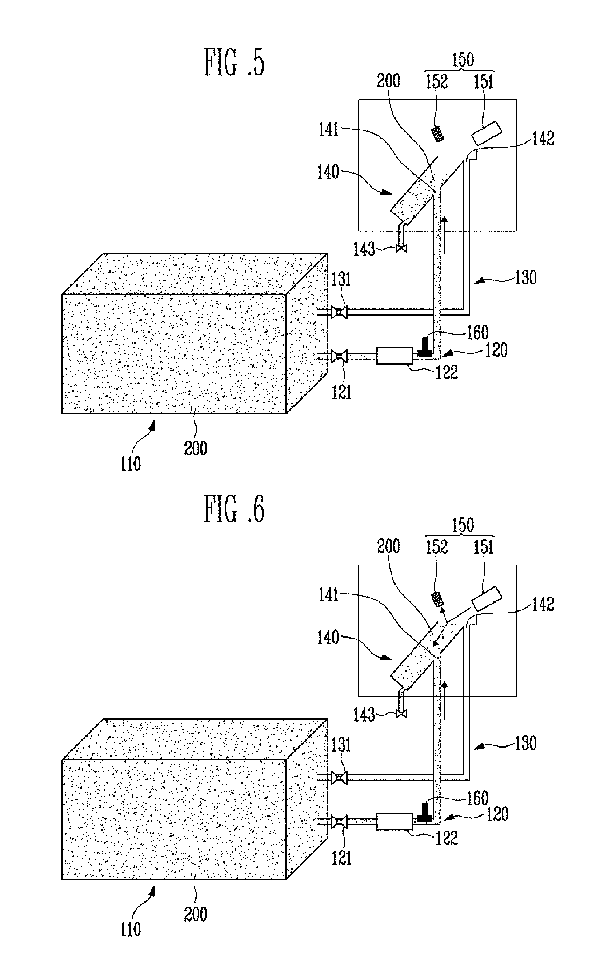

FIG. 4 illustrates a flowchart of a method for measuring turbidity according to an embodiment. FIGS. 5 to 7 are schematic views illustrating the method shown in FIG. 4. Hereinafter, the method according to this embodiment will be described with reference to FIGS. 4 to 7.

First, referring to FIGS. 4-5, the measuring fluid 200 stored in the first storage portion 110 is flowed into the measuring container 140 through the first pipe 120 (S110). In this case, the pipe connecting portion 141 is positioned lower than the second pipe connecting portion 142, and hence the measuring fluid 200 may gradually, e.g., slowly and constantly, fill the measuring container 140.

Next, referring to FIGS. 4 and 6, the turbidity of the measuring fluid 200 in the measuring container 140 is measured. In this case, the turbidity of the measuring fluid 200 is measured by the turbidity measuring portion 150 including the light emitting portion 151 and the light receiving portion 152 (S120). In detail, the light emitting portion 151 irradiates light onto the surface of the measuring fluid 200, and the light receiving portion 152 collects light reflected or refracted from the measuring fluid 200, thereby measuring the turbidity of the measuring fluid 200.

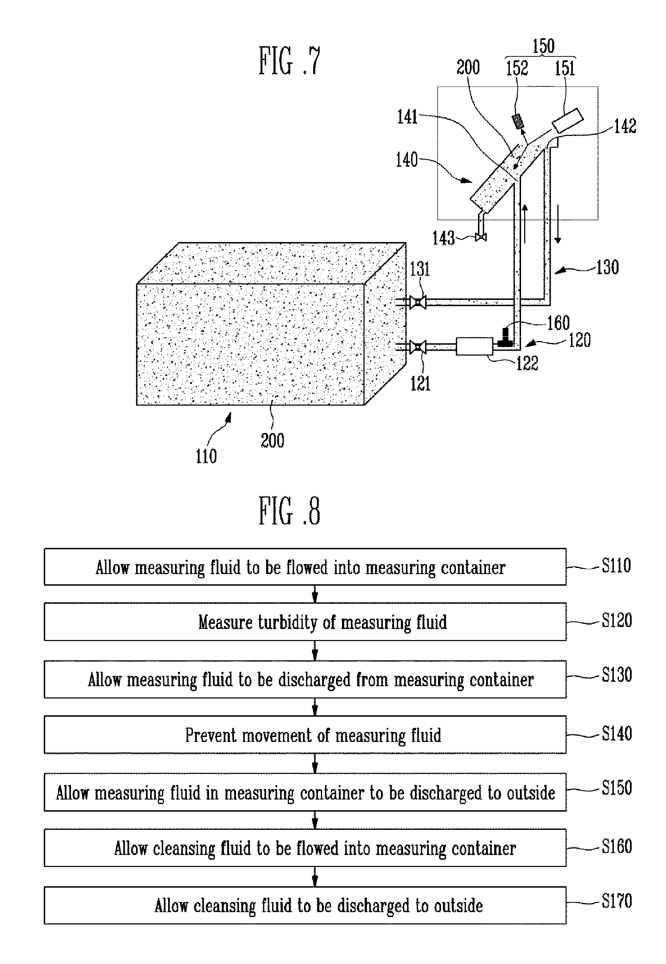

Next, referring to FIGS. 4 and 7, the measuring fluid 200 overflowing the measuring container 140 is discharged back to the first storage portion 110 through the second pipe 130 (S130). Thus, the measuring fluid 200 can be moved between the first storage portion 110 and the measuring container 140 through the first and second pipes 120 and 130.

Meanwhile, the processes described in this embodiment illustrate a process in which the measuring fluid 200 fills up the measuring container 140 and then overflows the measuring container 140 in an early stage. However, the processes may be almost simultaneously performed in real time while the measuring fluid 200 is continuously moved between the measuring container 140 and the first storage portion 110 in a subsequent process. Further, while the measuring fluid 200 flows into the measuring container 140, the pH measuring device 160 may be installed in the first pipe 120 to facilitate measurement of the pH of the measuring fluid 200.

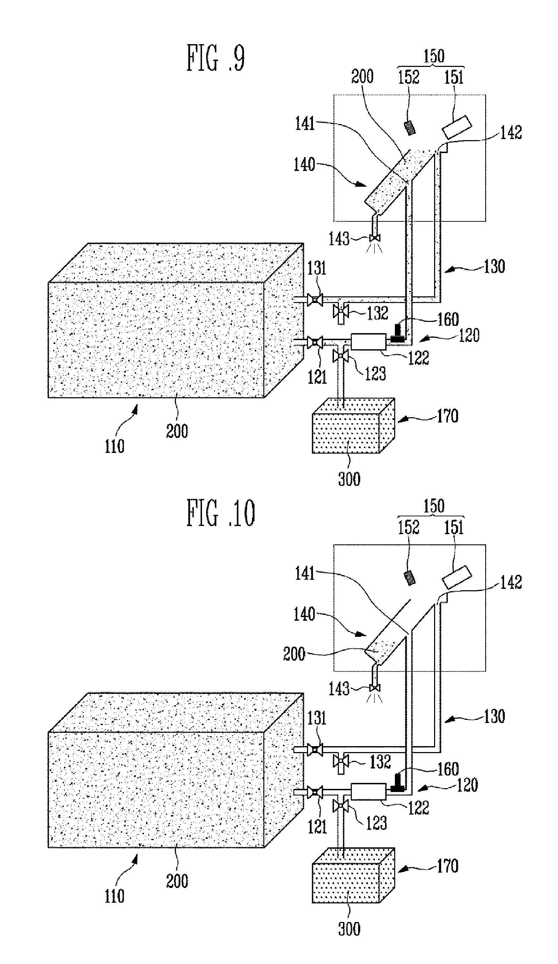

FIG. 8 illustrates a flowchart of a method for measuring turbidity according to another embodiment. FIGS. 9 to 12 are schematic views illustrating the method shown in FIG. 8. Hereinafter, the method according to this embodiment will be described with reference to FIGS. 8 to 12.

In this embodiment, allowing a flow of the measuring fluid 200 into the measuring container 140 (S110), measuring the turbidity of the measuring fluid 200 (S120), and discharging the flow of the measuring fluid 200 from the measuring container 140 (S130) have been described in the aforementioned embodiment. Therefore, in this embodiment, their descriptions will be omitted, and subsequent processes will be described.

First, referring to FIGS. 8-9, after the measurement of the turbidity of the measuring fluid 200 is completed, the movement of the measuring fluid 200 is prevented by closing the first valve 121 connected to the first pipe 120 and closing the second valve 131 connected to the second pipe 130 (S140). In this case, the flow of the measuring fluid 200 into the measuring container 140 may be blocked by first closing the first valve 121, and the second valve 131 may be closed after the measuring fluid 200 is sufficiently returned to the first storage portion 110 through the second pipe 130. Alternatively, the movement of the measuring fluid 200 may be blocked by simultaneously closing the first and second valves 121 and 131.

Next, Referring to FIGS. 8 and 10, the measuring fluid 200 in the measuring container 140 is discharged to the outside by opening the third valve 143 connected to the measuring container 140 (S150). In this case, the third valve 143 may be closed after the measuring fluid 200 is entirely discharged to the outside by opening the third valve 143.

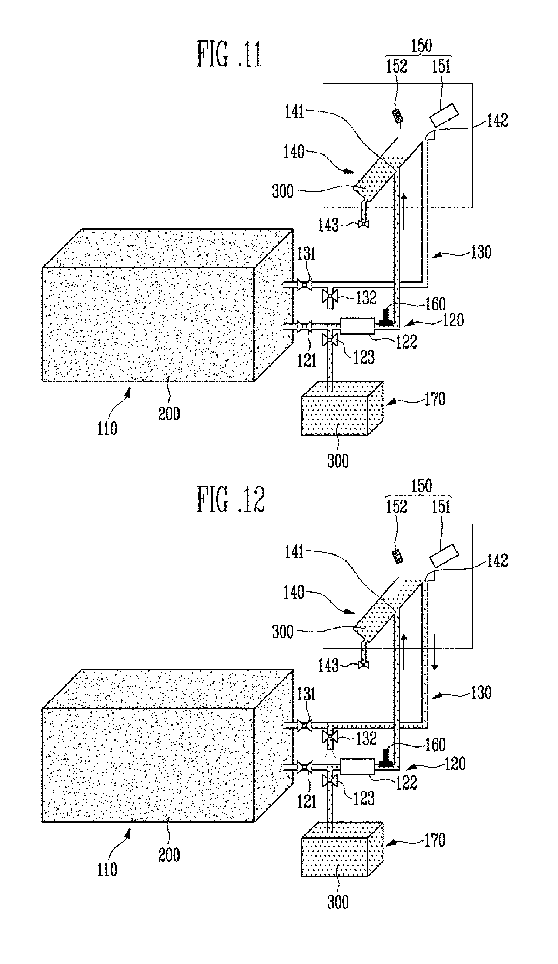

Next, Referring to FIGS. 8 and 11, the cleansing fluid 300 is flowed into the measuring container 140 from the second storage portion 170 connected to the first pipe 120 by opening the fourth valve 123 connected to the first pipe 120 (S160). In this case, the cleansing fluid 300 stored in the second storage portion 170 by the pump portion 122 may be flowed into the measuring container 140 through the first pipe 120. Thus, the film growth layer of the measuring fluid 200, formed in the first pipe 120 or the measuring container 140, can be removed.

Next, referring to FIGS. 8 and 12, the cleansing fluid 300 overflowing, e.g., filling, the measuring container 140 is discharged to the outside through the second pipe 130 by opening the fifth valve 132 connected to the second pipe 130 (S170). Thus, the film growth layer of the measuring fluid 200, formed in the second pipe 120, can be removed by the cleansing fluid 300.

It is noted that processes in this embodiment are not necessarily performed in sequence, and may be simultaneously performed. For example, the cleansing process may be performed, after forming the film growth layer in the solar cell at least eight times, while measuring the turbidity of the measuring fluid 200.

By way of summation and review, according to example embodiments, an apparatus for measuring turbidity of fluid includes at least two containers, i.e., a first storage portion and a measuring container, so a portion of the measuring fluid moves between the first storage portion and the measuring container during deposition of another portion of the measuring fluid, thereby measuring the turbidity of the measuring fluid in real time. Further, a pH measuring device may be installed in the first pipe, thereby measuring the pH of the measuring fluid. Further, a cleansing fluid may be flowed into the measuring container through a second storage portion connected to the first pipe, thereby removing a potential film growth layer of the measuring fluid from the pipes and the measuring container.

In contrast, when each layer of a solar cell is grown using a chemical solution, a thickness of the grown layer is very thin, so conventional measurement of a degree of homogeneity of the grown film may be difficult. Further, conventional measurement of a degree of homogeneity of the chemical solution used for growing the layer may be hard to perform in real time.

As discussed, embodiments of the invention provide an apparatus for measuring turbidity, comprising: a first storage unit (or first storage portion container) configured to store a measuring fluid therein; a measuring container connected to the first storage unit through first and second pipes; and a turbidity measuring unit configured to measure turbidity of the measuring fluid in the measuring container, at least a portion of the measuring fluid being moveable between the first storage unit and the measuring container through the first and second pipes. The turbidity measuring unit may comprise a single turbidity measuring device or comprise a number of distributed components.

In some embodiments, the turbidity of the measuring fluid may be measured by the turbidity measuring unit while the measuring container is being filed. In other embodiments, the measuring container may be filed and then the turbidity of the measuring fluid may be measured. In other embodiments still, the turbidity of the measuring fluid may be measured as the measuring container is emptied. In some embodiments, the turbidity of the measuring fluid may be measured as measuring fluid continuously flows from the first storage unit to the measuring container via the first pipe and back to the first storage unit via the second pipe.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. An apparatus for measuring turbidity, comprising:
a first storage unit configured to store a measuring fluid therein;
a measuring container connected to the first storage unit through first and second pipes; and
a turbidity measuring unit configured to measure turbidity of the measuring fluid in the measuring container, at least a portion of the measuring fluid being moveable between the first storage unit and the measuring container through the first and second pipes.

2. The apparatus as claimed in claim 1, wherein the first pipe is configured to transfer the at least portion of the measuring fluid from the first storage unit into the measuring container, and the second pipe is configured to transfer the at least portion of the measuring fluid from the measuring container into the first storage unit.

3. The apparatus as claimed in claim 1 or 2, wherein the measuring container includes:
a first pipe connecting unit connected to the first pipe; and
a second pipe connecting unit connected to the second pipe and positioned higher than the first pipe connecting unit, the measuring fluid flowing into the measuring container through the first pipe and flowing out of the measuring container through the second pipe.

4. The apparatus as claimed in any one of claims 1 to 3, wherein the first pipe includes a first valve configured to control the flow of the measuring fluid, and/or the second pipe includes a second valve configured to control the flow of the measuring fluid.

5. The apparatus as claimed in any one of claims 1 to 4, wherein the turbidity measuring unit includes:
a light emitting unit configured to irradiate light onto a surface of the measuring fluid; and
a light receiving unit configured to collect light irradiated from the light emitting unit and light spread from the measuring fluid.

6. The apparatus as claimed in claim 5, wherein the light emitting unit and the light receiving unit are positioned outside the measuring fluid, the light emitting unit and the light receiving unit being adjacent to a surface of the measuring fluid in the measuring container.

7. The apparatus as claimed in any one of claims 1 to 6, wherein the measuring container includes a third valve configured to discharge the measuring fluid from the measuring container.

8. The apparatus as claimed in any one of claims 1 to 7, wherein at least one of the first and second pipes includes a pH measuring device configured to measure pH of the measuring fluid.

9. The apparatus as claimed in any one of claims 1 to 8, further comprising a second storage unit connected to the first pipe, the second storage being configured to store a cleansing fluid therein;
optionally wherein the first pipe includes a fourth valve configured to control flow of the cleansing fluid in the first pipe.

10. The apparatus as claimed in claim 9, wherein the second pipe includes a fifth valve configured to discharge the cleansing fluid from the second pipe to the outside.

11. The apparatus as claimed in any one of claims 1 to 10, wherein the first pipe includes a pump unit configured to transfer the measuring fluid into the measuring container.

12. A method for measuring turbidity, the method comprising:
allowing at least a portion of a measuring fluid flow from a first storage unit into a measuring container through a first pipe;
measuring the turbidity of the measuring fluid in the measuring container with a turbidity measuring unit ; and
allowing the at least portion of the measuring fluid flow from the measuring container into the first storage unit through a second pipe.

13. The method as claimed in claim 12, wherein measuring the turbidity of the measuring fluid includes:
irradiating light onto a surface of the measuring fluid by a light emitting unit ; and
collecting light irradiated from the light emitting unit and light spread from the measuring fluid by a light receiving unit.

14. The method as claimed in claim 12 or 13, wherein allowing the at least portion of the measuring fluid flow from the first storage unit includes measuring pH of the measuring fluid using a pH measuring device connected to the first pipe.

15. The method as claimed in any one of claims 12 to 14, further comprising:
closing a first valve connected to the first pipe and closing a second valve connected to the second pipe, such that movement of the measuring fluid is prevented;
discharging the measuring fluid from the measuring container by opening a third valve connected to the measuring container;
closing the third valve connected to the measuring container;
opening a fourth valve connected to the first pipe, such that a cleansing fluid flows into the measuring container from a second storage unit connected to the first pipe; and
opening a fifth valve connected to the second pipe, such that the cleansing fluid is discharged from the measuring container through the second pipe.
